# EUROPEAN PATENT APPLICATION

(11) **EP 3 890 169 A1**
(43) Date of publication of application: **06.10.2021**
(21) Application number: 18941388.3
(22) Date of filing: 29.11.2018
(51) Int. Cl.: H02K 11/02, H05K 9/00

(54) **ELECTRIC DRIVING DEVICE**

(71) Applicant: Mitsubishi Electric Corporation, Tokyo 100-8310 (JP)
(72) Inventor: USHIO, Kohei, Tokyo 100-8310 (JP)
(74) Representative: Hoffmann Eitle
(86) International application number: PCT/JP2018/044015
(87) International publication number: WO 2020/110261

(57) **Abstract**

Provided is an electric driving device including a plate member which is made of a material having electroconductivity, and is arranged between a cover and a control unit main body. An electroconductive member made of a material having electroconductivity is provided to the cover. The plate member includes a first mounting portion and a second mounting portion. The first mounting portion is mounted to a control unit main body, and a second mounting portion is formed at a position different from a position of the first mounting portion. The electroconductive member has a connection portion which projects from the cover. At least one of the second mounting portion or the connection portion is more deformable than the plate member except for the second mounting portion.

## Description

### Technical Field

This invention relates to an electric driving device including a motor and a control unit.

### Background Art

Hitherto, there has been known a case for an electronic control unit, in which an electronic control unit is housed in a case main body and a peripheral edge portion of a board of the electronic control unit is held between a cover of the case and the case main body so as to hold the electric control unit in the case. Projecting portions to be brought into contact with the board are formed on the case main body. The cover is fastened to the case main body with screws to thereby press the peripheral edge portion of the board against the projecting portions of the case main body. Each of the case main body and the cover is made of a material having electroconductivity. Thus, when the case main body is electrically connected to a vehicle body serving as a ground, the electronic control unit is grounded through the case main body (see, for example, Patent Literature 1).

### Citation List

### Patent Literature

[PTL 1] JP 5889643 B2

### Summary of Invention

### Technical Problem

In the related-art case for an electronic control unit, which is described in Patent Literature 1, however, the board of the electronic control unit is directly pressed against the projecting portions of the case main body by the cover. Thus, when dimensional accuracy of each of the projecting portions of the case main body and the cover is low, there arises a risk in that pressure of the projecting portions of the case main body on the electronic control unit may become excessively large to damage the electronic control unit. Further, in the related-art case for an electronic control unit, which is described in Patent Literature 1, the cover is merely arranged on the peripheral edge portion of the board. Thus, noise generated from the electronic control unit is liable to be emitted to an outside.

This invention has been made to solve the problems described above, and has an object to provide an electric driving device in which emission of noise from a control unit main body to an outside of a housing and occurrence of breakage of a control unit can be suppressed.

### Solution to Problem

An electric driving device according to this invention includes: a housing including: a case having an opening portion; and a cover configured to close the opening portion; a motor housed in the case; a control unit which includes a control unit main body configured to control the motor, and is arranged between the cover and the motor; a plate member which is made of a material having electroconductivity, and is arranged between the cover and the control unit main body; and an electroconductive member which is made of a material having electroconductivity, and is provided to the cover, wherein the plate member includes: a first mounting portion mounted to the control unit main body; and a second mounting portion formed at a position different from a position of the first mounting portion, wherein the electroconductive member has a connection portion which projects from the cover, wherein the connection portion is mounted on the second mounting portion, and wherein at least one of the second mounting portion or the connection portion is more deformable than the plate member except for the second mounting portion.

### Advantageous Effects of Invention

According to the electric driving device of this invention, emission of noise from the control unit main body to the outside of the housing and occurrence of breakage of the control unit can be suppressed.

### Brief Description of Drawings

FIG. 1 is a sectional view for illustrating an electric driving device according to a first embodiment of this invention.
FIG. 2 is an electric circuit diagram of the electric driving device of FIG. 1.
FIG. 3 is an enlarged sectional view for illustrating a connection portion of FIG. 1.
FIG. 4 is a top view for illustrating the connection portion of FIG. 3.
FIG. 5 is a sectional view for illustrating another example of the electric driving device according to the first embodiment of this invention.
FIG. 6 is a sectional view of a main part of an electric driving device according to a second embodiment of this invention and is an illustration of a state in which an electroconductive member for plate connection is mounted to a plate member.
FIG. 7 is a top view for illustrating a connection portion of FIG. 6.
FIG. 8 is a sectional view of a main part of an electric driving device according to a third embodiment of this invention and is an illustration of a state in which an electroconductive member for plate connection is mounted to a plate member.
FIG. 9 is a top view for illustrating a connection portion of FIG. 8.
FIG. 10 is a sectional view of a main part of an electric driving device according to a fourth embodiment of this invention and is an illustration of a state in which an electroconductive member for plate connection is mounted to a plate member.
FIG. 11 is a sectional view of a main part of an electric driving device according to a fifth embodiment of this invention and is an illustration of a state in which an electroconductive member for plate connection is mounted to a plate member.
FIG. 12 is a sectional view of a main part of an electric driving device according to a sixth embodiment of this invention and is an illustration of a state in which an electroconductive member for plate connection is mounted to a plate member.

### Description of Embodiments

Now, embodiments of this invention are described with reference to the drawings.

### First Embodiment

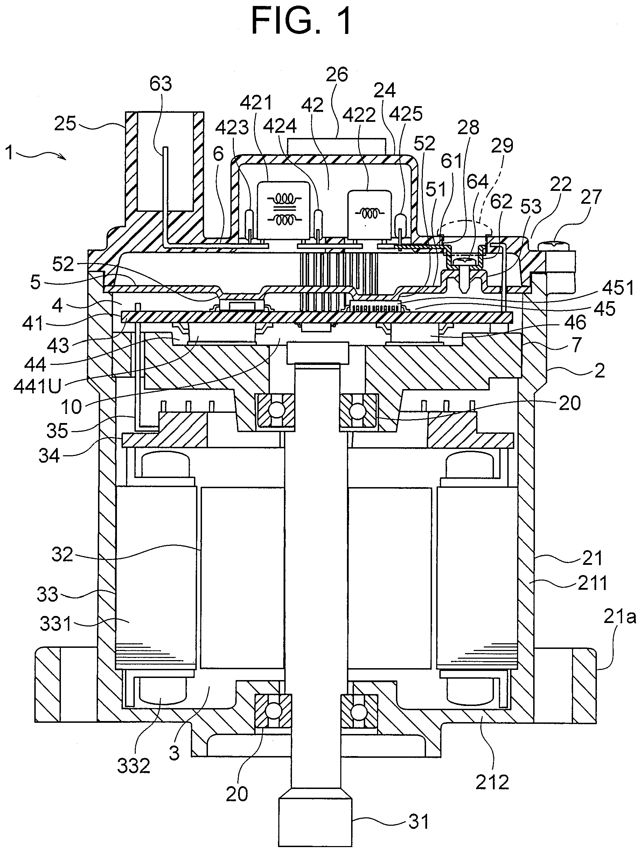

FIG. 1 is a sectional view for illustrating an electric driving device according to a first embodiment of this invention. An electric driving device 1 according to this embodiment is used as a driving device for a vehicle electric power steering device to be mounted on a vehicle such as an automobile. The electric driving device 1 includes a housing 2, a motor 3, a control unit 4, a plate member 5, a frame 7, and a plurality of electroconductive members 6.

The housing 2 includes a case 21 and a cover 21. The case 21 has an opening portion. The cover 22 is configured to close the opening portion of the case 21.

The case 21 is made of a material having electroconductivity and thermal conductivity. In this example, the case 21 is made of a metal such as aluminum. Further, the case 21 includes a cylindrical portion 211 and an end wall portion 212. The cylindrical portion 211 has an axis. The end wall portion 212 is configured to close one end portion of the cylindrical portion 211 in an axial direction of the cylindrical portion 211. The axis of the cylindrical portion 211 also serves as an axis of the case 21.

A through hole is formed in a central portion of the end wall portion 212. A plurality of mounting portions 21a are formed on an outer peripheral portion of the end wall portion 212. A bolt passage hole for allowing passage of a bolt is formed in each of the mounting portions 21a.

The opening portion of the case 21 is formed at the other end portion of the cylindrical portion 211 in the axial direction. The cover 22 is mounted to the other end portion of the cylindrical portion 211 in the axial direction with a screw 27 in a state of closing the opening portion of the case 21. The cover 22 is made of a material having an electrical insulation property. In this example, a resin is used as the material for forming the cover 22.

The cover 22 has a filter chamber 24 which is open to an inside of the housing 2. The filter chamber 24 is a space defined by a recess which is formed in a substantially central portion of the cover 22 in such a manner as to project toward an outer side of the housing 2.

A motor 3 is housed in the case 21. The control unit 4 is arranged between the motor 3 and the cover 22. The frame 7 is arranged between the motor 3 and the control unit 4.

The frame 7 is made of a material having electroconductivity and thermal conductivity. In this example, the frame 7 is made of a metal such as aluminum. The frame 7 has such a shape that the frame 7 is fitted to an inner surface of the cylindrical portion 211. The frame 7 is mounted to the case 21 under a state in which an outer peripheral portion of the frame 7 is in contact with the inner surface of the cylindrical portion 211. As a result, the frame 7 is electrically and thermally connected to the case 21. A through hole is formed in a central portion of the frame 7.

The motor 3 includes an output shaft 31, a rotor 32, and a stator 33. The output shaft 31 is arranged coaxially with the case 21. The rotor 32 is fixed to the output shaft 31. The stator 33 has a cylindrical shape and surrounds an outer peripheral portion of the rotor 32. In this example, the motor 3 is a three-phase brushless motor.

The output shaft 31 has a first end portion and a second end portion. The first end portion of the output shaft 31 passes through the through hole formed in the end wall portion 212. The second end portion of the output shaft 31 passes through the through hole formed in the frame 7. The output shaft 31 is rotatably supported in the end wall portion 212 and the frame 7 through bearings 20 fitted into the through holes, respectively. The first end portion of the output shaft 31 serves as an output portion of the electric driving device 1.

The rotor 32 includes a rotor core and a plurality of permanent magnets. The rotor core is fixed to the output shaft 31. The plurality of permanent magnets are provided to the rotor core. A plurality of pole pairs are formed in the rotor 32 by the plurality of permanent magnets. The rotor 32 is rotated integrally with the output shaft 31 about an axis of the output shaft 31.

The stator 33 is fixed to the inner surface of the cylindrical portion 211. The stator 33 is arranged coaxially with the output shaft 31. A gap is defined between an inner peripheral surface of the stator 33 and an outer peripheral surface of the rotor 32.

The stator 33 includes a stator core 331 and stator windings 332 of three phases. The stator core 331 has a cylindrical shape. The stator windings 332 of three phases are provided to the stator core 331. In this example, the stator windings 332 of three phases are connected in a star connection configuration. The stator windings 332 of three phases may also be connected in a delta connection configuration. The stator winding 332 of each phase may be provided to the stator core 331 in distributed winding or may be provided to the stator core 331 in concentrated winding. Further, the motor 3 may be, for example, a two-pole two-pair brushed motor.

A connection ring 34 having an annular shape is supported on the stator core 331. The connection ring 34 is arranged between the stator 33 and the frame 7. Three lead-out lines 35 passing through the frame 7 are mounted to the connection ring 34. The stator winding 332 of each phase is connected to the control unit 4 through each of the lead-out lines 35. In FIG. 1, only one lead-out line 35 of the three lead-out lines 35 is illustrated.

The control unit 4 is configured to supply currents to the stator windings 332 of respective phases through the three lead-out lines 35. The rotor 32 is rotated integrally with the output shaft 31 by the supply of the current to the stator winding 332 of each phase.

The control unit 4 includes a control unit main body 41 and a filter portion 42. The control unit main body 41 is mounted to the frame 7. The filter portion 42 is arranged in the filter chamber 24 of the cover 22.

The control unit main body 41 is configured to regulate the current to the stator winding 332 of each phase to control the motor 3. Further, the control unit main body 41 includes a board 43, an inverter circuit 44, a control circuit 45, and a power supply relay 46. The inverter circuit 44, the control circuit 45, and the power supply relay 46 are each mounted on the board 43.

The board 43 is arranged in such a manner as to be orthogonal to the axis of the output shaft 31. A pattern made of a metal, which is configured to electrically connect the inverter circuit 44, the control circuit 45, and the power supply relay 46, is printed on the board 43.

The rotation of the output shaft 31 is detected by a rotation sensor 10. The rotation sensor 10 includes a sensor magnet and a sensor portion. The sensor magnet is a permanent magnet provided at the second end portion of the output shaft 31. The sensor portion is provided on the board 43. The sensor magnet of the rotation sensor 10 is rotated integrally with the output shaft 31. The sensor portion of the rotation sensor 10 is opposed to the sensor magnet in an axial direction of the output shaft 31. The sensor portion of the rotation sensor 10 is configured to detect a magnetic field of the sensor magnet, which changes in accordance with the rotation of the output shaft 31. In this manner, the rotation sensor 10 generates information in accordance with the rotation of the output shaft 31.

The rotation sensor 10 may be a resolver sensor. The resolver sensor includes a sensor portion and a sensor rotor. The sensor portion is fixed to the frame 7. The sensor rotor is provided at the second end portion of the output shaft 31. The sensor rotor is arranged at the same position as the sensor portion in the axial direction of the output shaft 31. Further, the sensor rotor is rotated integrally with the output shaft 31. The sensor rotor is an electromagnetic steel member having a plurality of recess/projection portions arranged in a circumferential direction of the sensor rotor. The sensor portion of the resolver sensor is configured to detect a magnetic field that is changed with the rotation of the sensor rotor. Even when the rotation sensor 10 is a resolver sensor, the rotation sensor 10 generates information in accordance with the rotation of the output shaft 31.

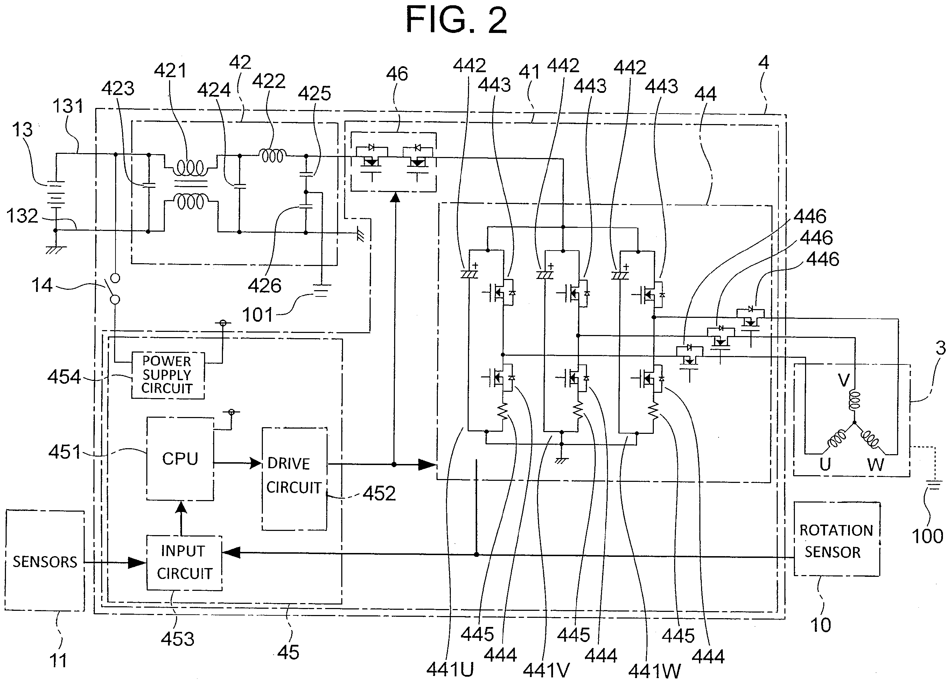

Now, FIG. 2 is an electric circuit diagram of the electric driving device 1 of FIG. 1. A battery 13 is mounted in the vehicle. A positive terminal of the battery 13 is electrically connected to the filter portion 42 through a battery power supply line 131. A negative terminal of the battery 13 is electrically connected to the filter portion 42 through a ground line 132. The ground line 132 is electrically connected to a vehicle body serving as a body ground. In this manner, the ground line 132 is grounded.

The control circuit 45 includes a central processing unit (CPU) 451, a drive circuit 452, an input circuit 453, and a power supply circuit 454.

An ignition switch 14 is electrically connected between the battery power supply line 131 and the power supply circuit 454. When the ignition switch 14 is closed, the power supply circuit 454 supplies power from the battery 13 to the control circuit 45.

Information from sensors 11 including a plurality of sensors provided in the vehicle and information from the rotation sensor 10 configured to detect the rotation of the output shaft 31 are transmitted to the input circuit 453. The sensors 11 include a torque sensor and a velocity sensor. The torque sensor is configured to detect a torque generated by steering of a steering wheel. The velocity sensor is configured to detect a velocity of the vehicle.

The information from the rotation sensor 10 and the information from the sensors 11 are transmitted from the input circuit 453 to the CPU 451. The CPU 451 is configured to compute a current value corresponding to a control amount for rotating the output shaft 31 of the motor 3 based on the information from the rotation sensor 10 and the information from the sensors 11. The current value computed by the CPU 451 is a current value in accordance with an assist torque that is needed to assist a steering force.

Information of the current value computed by the CPU 451 is transmitted from the CPU 451 to the drive circuit 452. The drive circuit 452 is configured to output an inverter drive signal in accordance with the information of the current value received from the CPU 451 to the inverter circuit 44. Further, the drive circuit 452 outputs a relay drive signal different from the inverter drive signal to the inverter circuit 44 and the power supply relay 46 in accordance with a command from the CPU 451.

The inverter circuit 44 includes a U-phase power module 441U, a V-phase power module 441V, and a W-phase power module 441W. The U-phase power module 441U, the V-phase power module 441V, and the W-phase power module 441W are connected in parallel.

The U-phase power module 441U, the V-phase power module 441V, and the W-phase power module 441W are individually electrically connected to the stator windings 332 of a U-phase, a V-phase, and a W-phase through the lead-out lines 35, respectively. Circuit configurations of the U-phase power module 441U, the V-phase power module 441V, and the W-phase power module 441W are the same for the stator windings 332 of the U-phase, the V-phase, and the W-phase, respectively.

Each of the U-phase power module 441U, the V-phase power module 441V, and the W-phase power module 441W includes a capacitor 442, an upper-arm switching element 443, a lower-arm switching element 444, a shunt resistor 445, and a motor relay switching element 446. In each of the U-phase power module 441U, the V-phase power module 441V, and the W-phase power module 441W, the capacitor 442, the upper-arm switching element 443, the lower-arm switching element 444, the shunt resistor 445, and the motor relay switching element 446 are integrated by molding.

In each of the U-phase power module 441U, the V-phase power module 441V, and the W-phase power module 441W, the capacitor 442 is connected in parallel to a constituent part in which the upper-arm switching element 443, the lower-arm switching element 444, and the shunt resistor 445 are connected in series. Further, in each of the U-phase power module 441U, the V-phase power module 441V, and the W-phase power module 441W, the stator winding 332 of the motor 3 is electrically connected between the upper-arm switching element 443 and the lower-arm switching element 444 through the motor relay switching element 446.

Each of the capacitors 442 is a capacitor configured to suppress noise. Each of the shunt resistors 445 is a resistor configured to detect the current.

Each of the motor relay switching elements 446 is configured to perform an on-operation and an off-operation in accordance with the relay drive signal. Electrical connection between the inverter circuit 44 and the stator winding 332 is implemented and interrupted based on the on-operation and the off-operation of the motor relay switching element 446. In this manner, the currents from the U-phase power module 441U, the V-phase power module 441V, and the W-phase power module 441W to the stator windings 332 of the U-phase, the V-phase, and the W-phase can be individually supplied and stopped based on the operations of the motor relay switching elements 446, respectively.

Each of the upper-arm switching elements 443 and the lower-arm switching elements 444 repeats switching the on-operation and the off-operation to thereby regulate a three-phase AC current supplied to the stator windings 332.

Information of a difference in potential between both end portions of each of the shunt resistors 445 and information of a voltage across terminals of each of the stator windings 332 are also transmitted to the input circuit 453. The CPU 451 computes a difference between a detection value obtained based on the above-mentioned information and the computed current value to perform so-called feedback control. In this manner, the inverter drive signal in accordance with the current supplied to the motor 3 is transmitted from the drive circuit 452 to the inverter circuit 44.

The inverter circuit 44 switches the upper-arm switching elements 443 and the lower-arm switching elements 444 of the U-power module 441U, the V-phase power module 441V, and the W-phase power module 441W in accordance with the inverter drive signal to thereby supply the three-phase AC current to the motor 3. As a result, the motor 3 generates an output for assisting the steering force.

In the control unit main body 41, noise is generated due to pulse width modulation (PWM) control of the current of the inverter circuit 44. The filter portion 42 is configured to prevent emission of noise from the control unit main body 41 to an outside. The filter portion 42 is called an "electromagnetic interference (EMI) filter".

The filter portion 42 includes a common-mode coil 421, a normal-mode coil 422, X-capacitors 423 and 424, and Y-capacitors 425 and 426.

The common-mode coil 421 is a coil configured to remove the noise between the battery power supply line 131 and the ground line 132. The normal-mode coil 422 is a coil configured to remove the noise in the battery power supply line 131. The common-mode coil 421 is electrically connected between the battery power supply line 131 and the ground line 132. The normal-mode coil 422 is electrically connected between the common-mode coil 421 and the power supply relay 46.

The X-capacitors 423 and 424 are called "across-the-line capacitors". The X-capacitors 423 and 424 are electrically connected between the battery power supply line 131 and the ground line 132 on the battery 13 side and the inverter circuit 44 side of the common-mode coil 421, respectively.

The Y-capacitors 425 and 426 are called "line bypass capacitors". The Y-capacitors 425 and 426 are electrically connected in series between the battery power supply line 131 and the ground line 132. A midpoint between the two Y-capacitors 425 and 426 that are connected in series is electrically connected to the case 21 serving as a case ground 101.

The power supply relay 46 is electrically connected between the filter portion 42 and the inverter circuit 44. Further, the power supply relay 46 includes two switching elements. The power supply relay 46 implements and interrupts electrical connection between the filter portion 42 and the inverter circuit 44 in accordance with the relay drive signal from the drive circuit 452. When the electrical connection between the filter portion 42 and the inverter circuit 44 is interrupted by the power supply relay 46, the supply of the current from the battery 13 to the motor 3 is stopped.

The CPU 451 has an abnormality detection function of detecting an abnormality in, for example, the sensors 11, the drive circuit 452, the inverter circuit 44, and the stator windings 332 based on the information from the input circuit 453. At the time of detecting an abnormality, the CPU 451 controls at least one of the power supply relay 46 or the inverter circuit 44 in accordance with the abnormality. When the supply of the current to only one of the stator windings 332 of the phases is stopped, the upper-arm switching element 443, the lower-arm switching element 444, and the motor relay switching element 446 of one of the U-phase power module 441U, the V-phase power module 441V, and the W-phase power module 441W are switched off by the control of the CPU 451. When the supply of the current to the motor 3 itself is stopped, the power supply relay 46 is switched off by the control of the CPU 451.

As illustrated in FIG. 1, the control unit main body 41 is housed in the case 21. The emission of noise generated from the control unit main body 41 to the outside is suppressed by the case 21 having electroconductivity. The case 21 is mounted to the vehicle body with the bolts inserted into the bolt passage holes of the mounting portions 21a. As a result, the case 21 is electrically connected to the vehicle body serving as a body ground 100 of FIG. 2. When the case 21 is electrically connected to the body ground 100, the motor 3 is grounded through the case 21.

The board 43 has a first surface and a second surface, which are opposed in a thickness direction of the board 43. The board 43 is arranged under a state in which the second surface of the board 43 faces the frame 7.

Electronic components of the control unit 4 are heat generating components, which generate heat when the current flows therethrough. A plurality of electronic components included in the control circuit 45 are mounted on the first surface of the board 43 as first heat generating components. A plurality of electronic components, which are included in the inverter circuit 44 and the power supply relay 46, are mounted on the second surface of the board 43 as second heat generating components. Thus, the CPU 451 is mounted on the first surface of the board 43 as the first heat generating component. Further, the power supply relay 46, the U-phase power module 441U, the V-phase power module 441V, and the W-phase power module 441W are mounted in a dispersed manner on the second surface of the board 43 as the second heat generating components. In FIG. 1, in the inverter circuit 44, only the U-phase power module 441U is illustrated.

The power supply relay 46, the U-phase power module 441U, the V-phase power module 441V, and the W-phase power module 441W are arranged on the frame 7 through intermediation of bond or grease having an insulating property and thermal conductivity. With this arrangement, heat from each of the power supply relay 46, the U-phase power module 441U, the V-phase power module 441V, and the W-phase power module 441W is radiated to the case 21 through the frame 7. In this manner, the frame 7 functions as a heat sink for the control unit main body 41.

The control circuit 45 is mounted on the first surface and the second surface of the board 43. As a result, the control circuit 45 includes the first heat generating components mounted on the first surface of the board 43 and the second heat generating components mounted on the second surface of the board 43.

The plate member 5 is made of a material having electroconductivity and thermal conductivity. In this example, the plate member 5 is made of a metal such as aluminum. Further, the plate member 5 is arranged between the control unit main body 41 and the cover 22. With this arrangement, the plate member 5 covers the control unit main body 41 inside the case 21. The plate member 5 has such a shape that the plate member 5 is fitted to the inner surface of the cylindrical portion 211 of the case 21, specifically, such a shape that the plate member 5 closes the opening portion of the case 21. An outer peripheral portion of the plate member 5 is held between the case 21 and the cover 22.

The plate member 5 is held inside the housing 2 under a state in which the outer peripheral portion of the plate member 5 is in contact with an inner surface of the case 21. As a result, the plate member 5 is electrically connected to the case 21. When the case 21 is electrically connected to the vehicle body serving as the body ground 100 of FIG. 2, the plate member 5 has the same potential as the case 21 and the vehicle body. Specifically, the plate member 5 is grounded. The emission of noise generated from the control unit main body 41 to the outside is suppressed not only by the case 21 but also by the plate member 5.

Further, the plate member 5 includes a plate main body portion 51, a plurality of first mounting portions 52, and a second mounting portion 53. The plate main body portion 51 is in contact with the inner surface of the case 21. The plurality of first mounting portions 52 are formed in the plate main body portion 51. The second mounting portion 53 is formed in the plate main body portion 51 so as to be located at a position different from a position of each of the first mounting portions 52.

The plate main body portion 51 has such an external shape that the plate main body portion 51 is fitted to the inner surface of the cylindrical portion 211. Further, the plate main body portion 51 is arranged in parallel to the board 43.

The first mounting portions 52 are individually mounted to the first heat generating components of the control circuit 45, respectively. Each of the first heat generating components of the control circuit 45 is connected to the board 43 through a solder portion. In this example, the first mounting portions 52 are mounted to the first heat generating components of the control circuit 45 through intermediation of bond or grease having an insulating property and thermal conductivity. As a result, heat from each of the first heat generating components of the control circuit 45 is radiated to the case 21 through the plate member 5. Specifically, the plate member 5 functions as a heat sink for the control circuit 45.

The second heat generating components of the control circuit 45 are thermally connected to the frame 7 through intermediation of bond or grease having an insulating property and thermal conductivity.

Further, each of the first mounting portions 52 projects from the plate main body portion 51 toward the control circuit 45. Each of the first mounting portions 52 has a mount surface to be mounted to the first heat generating component. A surface of each of the first mounting portions 52, which is on a back side of the mount surface, specifically, a surface of each of the first mounting portions 52 on the cover 22 side is recessed with respect to the plate main body portion 51.

A mounting hole 28 is formed in the cover 22. The mounting hole 28 is a through hole passing through the cover 22 in the axial direction of the output shaft 31. Further, the mounting hole 28 is opposed to the second mounting portion 53 in the axial direction of the output shaft 31.

A power supply connector 25 and a signal connector 26 are provided to the cover 22. In this example, the cover 22 including a wall of the filter chamber 24 and the power supply connector 25 are made of a resin material and formed by integral molding.

A power supply terminal 63 and a ground terminal are exposed inside the power supply connector 25. The power supply terminal 63 is electrically connected to the positive terminal of the battery 13 through the battery power supply line 131 of FIG. 2. The ground terminal is electrically connected to the negative terminal of the battery 13 through the ground line 132 of FIG. 2. The current from the battery 13 is supplied to the filter portion 42 through the power supply connector 25. The information from the sensors 11 is transmitted to the input circuit 453 of the control circuit 45 through the signal connector 26.

The plurality of electroconductive members 6 are provided to the cover 22. The plurality of electroconductive members 6 are integrated with the cover 22 by resin molding.

Each of the electroconductive members 6 is made of a material having electroconductivity and thermal conductivity. In this example, each of the electroconductive members 6 is made of a metal such as copper. Terminals of the components of the filter portion 42, specifically, the common-mode coil 421, the normal-mode coil 422, the X-capacitors 423 and 424, and the Y-capacitors 425 and 426 are connected to the plurality of electroconductive members 6. As a result, a circuit configuration of the filter portion 42, which is illustrated in FIG. 2, is formed.

At least an electroconductive member continuous with the power supply terminal 63, an electroconductive member continuous with the ground terminal, and an electroconductive member to which a terminal of one of the Y-capacitors 425 and 426 is connected are provided to the cover 22 as the electroconductive members 6.

The electroconductive member 6, to which one terminal of each of the Y-capacitors 425 and 426 is connected, serves as an electroconductive member 6 for plate connection, which is to be connected to the plate member 5. The electroconductive member 6 for plate connection includes electroconductive member main body portions 61 and a connection portion 62. The electroconductive member main body portions 61 are fixed to the cover 22. The connection portion 62 extends from the electroconductive member main body portions 61.

The electroconductive member main body portions 61 are embedded in the cover 22. The connection portion 62 projects from the cover 22 to an outside of the cover 22. A lid 29 configured to close the mounting hole 28 is mounted to the cover 22. The lid 29 covers the connection portion 62 of the electroconductive member 6 for plate connection.

The second mounting portion 53 projects from the plate main body portion 51 toward the connection portion 62. The second mounting portion 53 has a mount surface to which the connection portion 62 is to be mounted. A surface of the second mounting portion 53 on a back side of the mount surface, specifically, a surface of the second mounting portion on the control unit main body 41 side is recessed with respect to the plate main body portion 51.

A screw hole is formed in the second mounting portion 53. The connection portion 62 is mounted onto the second mounting portion 53 with a screw 64 that is driven into the screw hole of the second mounting portion 53. As a result, the connection portion 62 is in contact with the mount surface of the second mounting portion 53. The contact of the connection portion 62 with the second mounting portion 53 electrically and thermally connects the electroconductive member 6 for plate connection to the plate member 5. Specifically, the electroconductive member 6 for plate connection is electrically and thermally connected to the case 21 through the screw 64 and the plate member 5.

Thus, the electroconductive member 6 for plate connection, the screw 64, and the plate member 5 form a case ground line configured to electrically connect the midpoint between the two Y-capacitors 425 and 426 and the case ground 101 of FIG. 2. Further, heat from each of the first heat generating components of the control circuit 45 is radiated not only to the case 21 through the plate member 5 but also to an outside of the housing 2 through the plate member 5 and the electroconductive member 6 for plate connection.

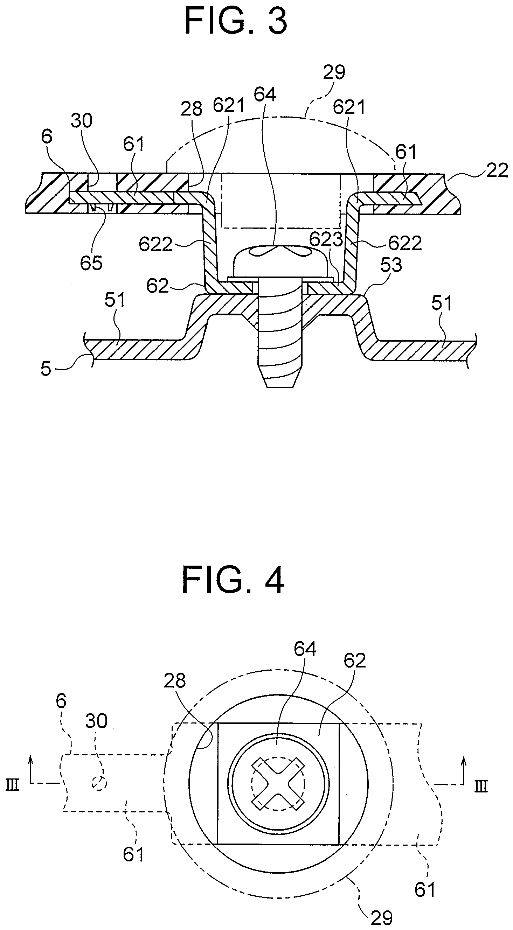

FIG. 3 is an enlarged sectional view for illustrating the connection portion 62 of FIG. 1. Further, FIG. 4 is a top view for illustrating the connection portion 62 of FIG. 3. FIG. 3 is a sectional view taken along the line III-III of FIG. 4. In the electroconductive member 6 for plate connection, the two electroconductive member main body portions 61 opposed to each other through a space of the mounting hole 28 therebetween are continuous through the connection portion 62. A terminal connection hole 65 is formed in one of the electroconductive member main body portions 61. The terminal connection hole 65 is exposed inside a through hole 30 formed in the cover 22. A terminal of one of the Y-capacitors 425 and 426 is connected to the terminal connection hole 65 of the electroconductive member main body portion 61.

The connection portion 62 projects from the two electroconductive member main body portions 61 toward the second mounting portion 53. Further, the connection portion 62 is more elastically deformable than the second mounting portion 53. Still further, the connection portion 62 is more elastically deformable than the plate member 5 except for the second mounting portion 53, specifically, the plate main body portion 51 and the first mounting portions 52. Still further, a load under which the connection portion 62 is deformed is set based on a withstand load of the control unit main body 41. A load received by the control unit main body 41 from the first mounting portions 52 of the plate member 5 is smaller than the withstand load of the control unit main body 41. In this example, a thickness of the connection portion 62 is smaller than a thickness of the second mounting portion 53. As a result, the connection portion 62 is more flexible than the second mounting portion 53.

The connection portion 62 includes a pair of root portions 621 each having a plate-like shape, a contact portion 623 having a plate-like shape, and a pair of connecting portions 622 each having a plate-like shape. The root portions 621 extend from the two electroconductive member main body portions 61, respectively, into the space of the mounting hole 28. The contact portion 623 is arranged at a position closer to the second mounting portion 53 than the pair of root portions 621. The connecting portions 622 are configured to connect the pair of root portions 621 and the contact portion 623. The contact portion 623 is continuous with end portions of the pair of connecting portions 622. The connection portion 62 is mounted to the second mounting portion 53 under a state in which the contact portion 623 is held in contact with the mount surface of the second mounting portion 53. A passage hole for allowing passage of the screw 64 is formed in the contact portion 623.

At the time of assembly of the cover 22 or under a state in which the connection portion 62 is pressed against the second mounting portion 53 with a pressing force generated at the time of tightening of the screw 64, pressure of the connection portion 62 on the second mounting portion 53 is alleviated through elastic deformation of the connection portion 62. Even under a state in which the connection portion 62 pulls the second mounting portion 53 due to the tightening of the screw 64, a force received by the plate member 5 from the connection portion 62 is alleviated through the elastic deformation of the connection portion 62. As a result, an excessive increase in pressure applied from the plate member 5 to each of the first heat generating components of the control circuit 45 and the solder portions is prevented.

In the electric driving device 1 described above, the electroconductive member 6 for plate connection, which is provided to the cover 22, has the connection portion 62 projecting from the cover 22. Further, the plate member 5 has the first mounting portions 52 mounted to the control unit main body 41 and the second mounting portion 53 to which the connection portion 62 is mounted. Still further, the connection portion 62 is more elastically deformable than the plate member 5 except for the second mounting portion 53, specifically, each of the plate main body portion 51 and the first mounting portions 52.

Thus, when the plate member 5 is electrically connected to the vehicle body, the plate member 5 is enabled to function as a shield configured to block the noise generated from the control unit main body 41. Thus, the emission of noise from the control unit main body 41 to the outside of the housing 2 can be suppressed by the plate member 5. Further, when a force is applied from the connection portion 62 to the plate member 5, the connection portion 62 can be positively elastically deformed. As a result, an excessive increase in pressure applied from the first mounting portions 52 of the plate member 5 to the control unit main body 41 can be prevented. Thus, occurrence of breakage of the control unit 4 can be suppressed.

Further, the connection portion 62 projects from the electroconductive member main body portions 61 toward the second mounting portion 53. Thus, the second mounting portion 53 is not required to be caused to significantly project from the plate main body portion 51. As a result, the plate member 5 can easily be processed to achieve reduction in cost. Further, processing for significantly deforming the plate member 5 can be eliminated. As a result, improvement of dimensional accuracy of the plate member 5 can also be achieved.

Further, the second mounting portion 53 projects from the plate main body portion 51 toward the connection portion 62. Thus, a position of the mount surface of the second mounting portion 53 can be set closer to the cover 22. As a result, the connection portion 62 can easily be mounted on the second mounting portion 53.

Further, the connection portion 62 is more elastically deformable than the second mounting portion 53. Thus, the connection portion 62 can be positively elastically deformed, and hence a problem which may be caused by unintended deformation of the plate member 5 can be prevented.

Further, the plate member 5 is electrically connected to the case 21 made of a material having electroconductivity. Thus, the plate member 5 can be electrically connected to the vehicle body through the case 21. As a result, the control unit 4 can be more reliably grounded.

Further, each of the plate member 5 and the case 21 is made of a material having thermal conductivity. Further, the control unit main body 41 includes the plurality of electronic components including the CPU 451 as the first heat generating components. Still further, the plate member 5 is mounted to the first heat generating components of the control unit main body 41 and the case 21. Thus, heat from the first heat generating components of the control unit main body 41 can be effectively radiated to the outside of the housing 2 through the plate member 5 and the case 21.

Further, each of the frame 7 and the case 21 is made of a material having thermal conductivity. Further, the control unit main body 41 includes the U-phase power module 441U, the V-phase power module 441V, the W-phase power module 441W, and the power supply relay 46 as the second heat generating components. Still further, each of the second heat generating components of the control unit main body 41 is arranged on the frame 7 mounted to the case 21 through intermediation of bond or grease having an insulating property and thermal conductivity. Thus, heat from each of the second heat generating components of the control unit main body 41 can be effectively radiated to the outside of the housing 2 through the frame 7 and the case 21.

Further, the electroconductive member 6 for plate connection, which has the connection portion 62, is different from the electroconductive member continuous with the power supply terminal 63 and the electroconductive member continuous with the ground terminal. Thus, a degree of freedom of each of a position of the connection portion 62 and a position of the second mounting portion 53 can be improved.

In the example described above, the second heat generating components, specifically, the inverter circuit 44 and the power supply relay 46 are mounted on the second surface of the board 43. However, the second heat generating components may be mounted on the frame 7.

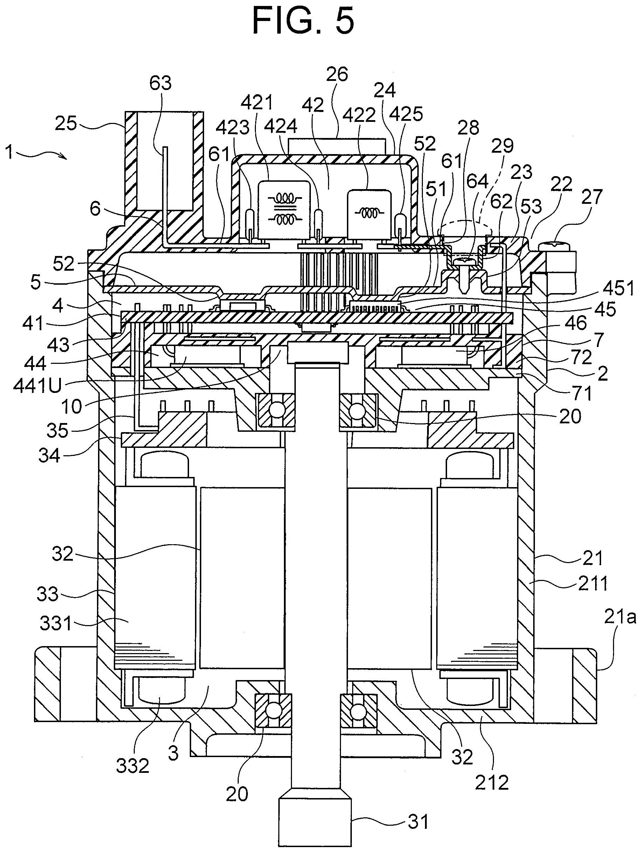

In this case, the frame 7 includes, as illustrated in FIG. 5, a heat radiation member 71 and a component mounting member 72. The heat radiation member 71 serves as a heat sink. The component mounting member 72 is arranged on the board 43 side of the heat radiation member 71. The component mounting member 72 is a member formed by integrating a plurality of terminals having electroconductivity with a resin. Further, in this case, the second heat generating components are mounted to the component mounting member 72. As a result, the second heat generating components are arranged in a space defined between the heat radiation member 71 and the component mounting member 72 so that heat radiation surfaces of the second heat generating components face the heat radiation member 71. Further, the second heat generating components are arranged on the heat radiation member 71 through intermediation of bond or grease having an insulating property and thermal conductivity. Further, in this case, power supply system terminals of the inverter circuit 44 and the power supply relay 46, specifically, power supply system terminals of the second heat generating components are electrically connected to the power supply terminal 63 through the terminals of the component mounting member 72. Signal system terminals of the inverter circuit 44 and the power supply relay 46 are directly electrically connected to the board 43 with, for example, solder. Further, in this case, the terminals of the component mounting member 72 electrically connected to a ground terminal of the power supply connector 25 are electrically connected to the heat radiation member 71.

### Second Embodiment

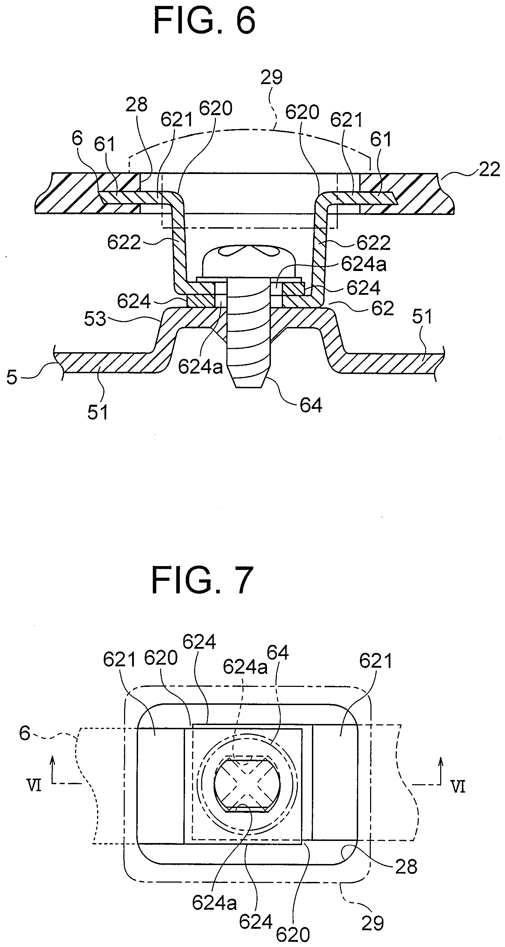

FIG. 6 is a sectional view of a main part of an electric driving device according to a second embodiment of this invention and is an illustration of a state in which an electroconductive member for plate connection is mounted to a plate member. FIG. 7 is a top view for illustrating a connection portion of FIG. 6. FIG. 6 is a sectional view taken along the line VI-VI of FIG. 7. The connection portion 62 has a pair of projecting portions 620 extending from the two electroconductive member main body portions 61 opposed to each other, respectively. The pair of projecting portions 620 are separate from each other. As a result, the pair of projecting portions 620 are deformable independently of each other.

Each of the projecting portions 620 has a root portion 621 having a plate-like shape, a contact portion 624 having a plate-like shape, and a connecting portion 622 having a plate-like shape. The root portion 621 extends from the electroconductive member main body portion 61 into the space of the mounting hole 28. The contact portion 624 is arranged at a position closer to the second mounting portion 53 than the root portion 621. The connecting portion 622 is configured to connect the root portion 621 and the contact portion 624. Each of the projecting portions 620 has a Z-like shape formed with the root portion 621, the connecting portion 622, and the contact portion 624.

Each of the contact portions 624 has a passage hole 624a for allowing passage of the screw 64 serving as a coupling member. Each of the passage holes 624a is, as illustrated in FIG. 7, an elongated hole formed along a longitudinal direction of the electroconductive member 6 for plate connection.

The contact portions 624 are superposed in order on the mount surface of the second mounting portion 53 in the axial direction of the output shaft 31. Further, the contact portions 624 overlap with each other so that positions of the passage holes 624a are aligned with each other. Further, when the screw 64 inserted into the passage holes 624a is driven into the screw hole of the second mounting portion 53, the contact portions 624 are mounted on the second mounting portion 53. As a result, the pair of projecting portions 620 are mounted together on the second mounting portion 53 with the screw 64.

One of the contact portions 624, which is closer to the second mounting portion 53, is in contact with the mount surface of the second mounting portion 53. Further, the contact portions 624 are in contact with each other. As a result, the electroconductive member 6 for plate connection is electrically and thermally connected to the plate member 5.

The mounting hole 28 has a rectangular shape as illustrated in FIG. 7. A direction along long sides of the rectangular shape of the mounting hole 28 matches the longitudinal direction of the electroconductive member 6 for plate connection. As a result, an increase in length of each of the root portions 621 of the projecting portions 620, which projects beyond the cover 22, is achieved.

When the contact portions 624 are fastened with the screw 64 under a state in which the contact portions 624 are superposed in order on the second mounting portion 53, a pressure generated by the tightening of the screw 64 on the second mounting portion 53 is applied to each of the contact portions 624. As a result, the pair of projecting portions 620 are elastically deformed in a direction in which the connecting portions 622 are separated away from each other or in a direction in which the connecting portions 622 are brought closer to each other. The force received by the second mounting portion 53 from the connection portion 62 is alleviated through the elastic deformation of the pair of projecting portions 620. The other configurations are the same as the configurations of the first embodiment.

In the electric driving device 1 described above, the pair of projecting portions 620 of the connection portion 62 are separate from each other. Further, the pair of projecting portions 620 are mounted together on the second mounting portion 53 with the screw 64. Thus, the pair of projecting portions 620 can be individually elastically deformed. As a result, the connection portion 62 can be more elastically deformable than in the first embodiment. Thus, an excessive increase in pressure applied from the plate member 5 to the control unit main body 41 can be more reliably prevented. Hence, the occurrence of breakage of the control unit 4 can be more reliably suppressed.

### Third Embodiment

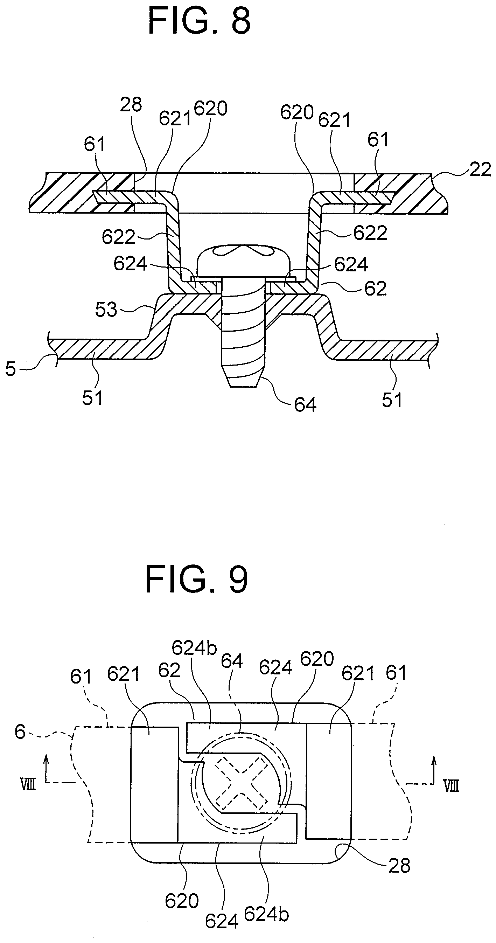

FIG. 8 is a sectional view of a main part of an electric driving device according to a third embodiment of this invention and is an illustration of a state in which an electroconductive member for plate connection is mounted to a plate member. FIG. 9 is a top view for illustrating a connection portion of FIG. 8. FIG. 8 is a sectional view taken along the line VIII-VIII of FIG. 9. Each of the contact portions 624 of the pair of projecting portions 620 has a narrow plate portion 624b having a width smaller than a width of each of the connecting portions 622. The contact portions 624 are arranged on the same flat surface under a state in which the narrow plate portions 624b are separate apart from each other in a width direction of the electroconductive member 6 for plate connection. As a result, a space of such an extent as to allow the screw 64 to pass therethrough is defined between the narrow plate portions 624b.

When the screw 64 inserted into the space between the narrow plate portions 624b is driven into the screw hole of the second mounting portion 53, the contact portions 624 are mounted on the second mounting portion 53. As a result, the pair of projecting portions 620 are mounted together on the second mounting portion 53 with the screw 64.

Each of the contact portions 624 is in contact with the mount surface of the second mounting portion 53. As a result, the electroconductive member 6 for plate connection is electrically and thermally connected to the plate member 5.

When the contact portions 624 are fastened with the screw 64, a pressure generated by the tightening of the screw 64 on the second mounting portion 53 is applied to each of the contact portions 624. As a result, the pair of projecting portions 620 are elastically deformed in the direction in which the connecting portions 622 are separated away from each other or in the direction in which the connecting portions 622 are brought closer to each other. The force received by the second mounting portion 53 from the connection portion 62 is alleviated through the elastic deformation of the pair of projecting portions 620. The other configurations are the same as the configurations of the second embodiment.

As described above, even when the pair of projecting portions 620 are mounted together on the second mounting portion 53 under a state in which the contact portions 624 are in contact with the second mounting portion 53, the connection portion 62 can be more elastically deformable as in the second embodiment. Thus, an excessive increase in pressure applied from the plate member 5 to the control unit main body 41 can be more reliably prevented. Hence, the occurrence of breakage of the control unit 4 can be more reliably suppressed.

### Fourth Embodiment

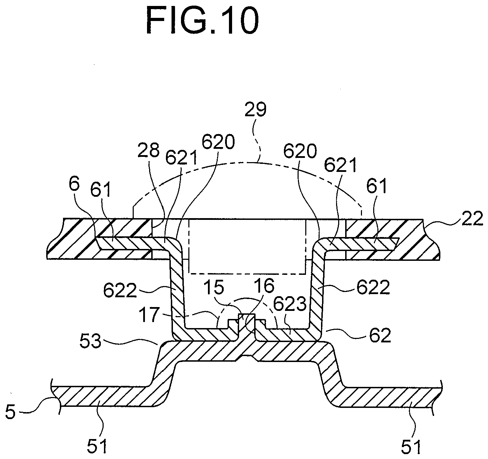

FIG. 10 is a sectional view of a main part of an electric driving device according to a fourth embodiment of this invention and is an illustration of a state in which an electroconductive member for plate connection is mounted to a plate member. A protruding portion 15 is formed on the mount surface of the second mounting portion 53. The protruding portion 15 protrudes from the mount surface of the second mounting portion 53 toward the connection portion 62. Further, the protruding portion 15 is made of the same material as the material of the second mounting portion 53.

An insertion hole 16 corresponding to a through hole for insertion of the protruding portion 15 is formed in the contact portion 623 that is continuous with the end portions of the pair of connecting portions 622. The connection portion 62 is mounted on the second mounting portion 53 under a state in which the protruding portion 15 is inserted into the insertion hole 16.

A gap is defined between an outer peripheral surface of the protruding portion 15 and an inner peripheral surface of the insertion hole 16 under the state in which the protruding portion 15 is inserted into the insertion hole 16. When the protruding portion 15 is inserted into the insertion hole 16, the protruding portion 15 is not press-fitted into the insertion hole 16. Thus, a force received by the second mounting portion 53 from the connection portion 62 is reduced.

An electroconductive material 17 configured to electrically and thermally connect the protruding portion 15 and the contact portion 623 covers the protruding portion 15 under a state in which the connection portion 62 is mounted on the second mounting portion 53. In this example, solder or an electroconductive adhesive is used as the electroconductive material 17. Further, the contact portion 623 is in contact with the second mounting portion 53 under the state in which the connection portion 62 is mounted on the second mounting portion 53. As a result, the electroconductive member 6 for plate connection is electrically and thermally connected to the plate member 5. The other configurations are the same as the configurations of the first embodiment.

In the electric driving device 1 described above, the protruding portion 15 is formed on the second mounting portion 53, and the insertion hole 16 into which the protruding portion 15 is inserted is formed in the contact portion 623 of the connection portion 62. Thus, when the protruding portion 15 is inserted into the insertion hole 16, the connection portion 62 can be mounted on the second mounting portion 53. As a result, work for mounting the connection portion 62 onto the second mounting portion 53 can easily be performed. Further, a coupling member configured to mount the connection portion 62 onto the second mounting portion 53 can be eliminated. As a result, the number of components of the electric driving device 1 can be reduced to thereby achieve reduction in cost.

In the above-mentioned example, the protruding portion 15 is formed on the second mounting portion 53, and the insertion hole 16 is formed in the contact portion 623 of the connection portion 62. However, the protruding portion 15 may be formed on the contact portion 623 of the connection portion 62, and the insertion hole 16 into which the protruding portion 15 is to be inserted may be formed in the second mounting portion 53.

Further, in the above-mentioned example, the electroconductive material 17 covers the protruding portion 15. However, the electroconductive material 17 may be omitted.

### Fifth Embodiment

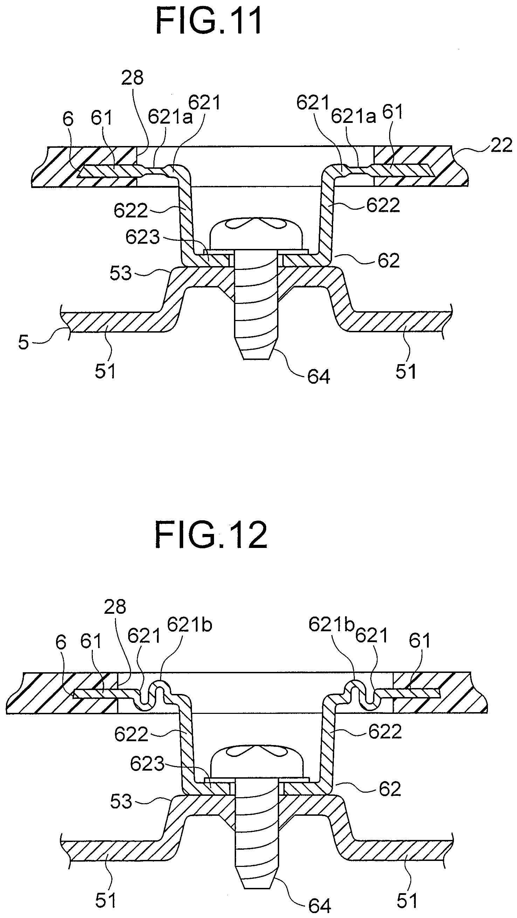

FIG. 11 is a sectional view of a main part of an electric driving device according to a fifth embodiment of this invention and is an illustration of a state in which an electroconductive member for plate connection is mounted on a plate member. A part of each of the pair of root portions 621 is formed as a thin portion 621a. A thickness of the thin portion 621a is smaller than a thickness of the connection portion 62 except for the thin portion 621a. The other configurations are the same as the configurations of the first embodiment.

In the electric driving device 1 described above, a part of each of the root portions 621 is formed as the thin portion 621a. Thus, each of the thin portions 621a can be more elastically deformable than the connection portion 62 except for the thin portions 621a. As a result, the connection portion 62 can be more elastically deformable. Thus, an excessive increase in pressure applied from the first mounting portions 52 of the plate member 5 to the control unit main body 41 can be more reliably prevented. Hence, the occurrence of breakage of the control unit 4 can be more reliably suppressed.

In the above-mentioned example, the thickness of each of the thin portions 621a is smaller than the thickness of the connection portion 62 except for the thin portions 621a. However, a dimension of each of the thin portions 621a in the width direction may be set to be smaller than a dimension of the connection portion 62 except for the thin portions 621a in the width direction.

Still further, in the above-mentioned example, only a part of the root portion 621 is formed as the thin portion 621a. However, the entire root portion 621 may be formed as the thin portion 621a. Further, a part or entirety of at least one of the connecting portion 622 or the contact portion 624 may be formed as the thin portion 621a.

Still further, in the above-mentioned example, a part of the connection portion 62 is formed as the thin portions 621a. However, a part or entirety of the second mounting portion 53 of the plate member 5 may be formed as a thin portion. In this case, a thickness of the thin portion of the second mounting portion 53 is set to be smaller than a thickness of the plate main body portion 51.

### Sixth Embodiment

FIG. 12 is a sectional view of a main part of an electric driving device according to a sixth embodiment of this invention and is an illustration of a state in which an electroconductive member for plate connection is mounted on a plate member. A part of each of the pair of root portions 621 is formed as a bent portion 621b bent into an S-like shape. The other configurations are the same as the configurations of the first embodiment.

In the electric driving device 1 described above, a part of each of the root portions 621 is formed as the bent portion 621b. Thus, each of the bent portions 621b can be more elastically deformable than the connection portion 62 except for the bent portions 621b. As a result, the connection portion 62 can be more elastically deformable. Thus, an excessive increase in pressure applied from the first mounting portions 52 of the plate member 5 to the control unit main body 41 can be more reliably prevented. Hence, the occurrence of breakage of the control unit 4 can be more reliably suppressed.

In the first to third, fifth, and sixth embodiments, the screw 64 is used as the coupling member configured to mount the connection portion 62 onto the second mounting portion 53. However, the coupling member is not limited to the screw 64 as long as the coupling member enables mechanical mounting of the connection portion 62 on the second mounting portion 53. For example, a rivet may be used as the coupling member. Further, the connection portion 62 may be mounted on the second mounting portion 53 by welding, thermal caulking, or caulking without using the coupling member. As the thermal caulking, for example, fusing is given as an example.

In each of the embodiments described above, only a small current flows through the drive circuit 452. Thus, the drive circuit 452 is included in the control circuit 45. However, the drive circuit 452 may be included in the inverter circuit 44. In this case, the drive circuit 452 is mounted on the second surface of the board 43.

Further, when the drive circuit 452 is included in the inverter circuit 44, the drive circuit 452 may be mounted not on the board 43 but on the frame 7. In this case, the frame 7 includes, as in FIG. 5, the heat radiation member 71 serving as a heat sink and the component mounting member 72 arranged on the board 43 side of the heat radiation member 71. The component mounting member 72 is a member formed by integrating the plurality of terminals having electroconductivity with a resin. Further, in this case, the drive circuit 452 is mounted on the component mounting member 72. As a result, the electronic components included in the drive circuit 452 are arranged in the space defined between the heat radiation member 71 and the component mounting member 72 of the frame 7 so that heat radiation surfaces of the electronic components face the heat radiation member 71 of the frame 7. Further, in this case, the power supply system terminals of the inverter circuit 44 and the power supply relay 46 are electrically connected to the power supply terminal 63 through the terminals of the component mounting member 72, and the signal system terminals of the inverter circuit 44 and the power supply relay 46 are electrically connected to the board 43. Further, in this case, the terminal of the component mounting member 72, which is electrically connected to the ground terminal of the power supply connector 25, is electrically connected to the heat radiation member 71.

Further, in each of the embodiments described above, the power supply relay 46 is arranged separately from the inverter circuit 44. However, a large current, which may cause heat generation, flows through the power supply relay 46. Thus, the power supply relay 46 may be included in the inverter circuit 44.

Further, in each of the embodiments described above, the thickness of the connection portion 62 is smaller than the thickness of the second mounting portion 53. As a result, the connection portion 62 is more elastically deformable than the second mounting portion 53. However, a stiffness of the material for forming the plate member 5 and a stiffness of the material for forming the electroconductive member 6 for plate connection may be set to be different from each other to make the connection portion 62 more elastically deformable than the second mounting portion 53. For example, the plate member 5 may be made of a so-called "H material" obtained by hardening a metal material, and the electroconductive member 6 for plate connection may be made of a so-called "0 material" obtained by annealing a metal material.

Still further, in each of the embodiments described above, the connection portion 62 is more elastically deformable than the second mounting portion 53. However, the connection portion 62 is only required to be more deformable than the second mounting portion 53 regardless of whether the deformation is elastic deformation or plastic deformation. Thus, the connection portion 62 may be more plastically deformable than the second mounting portion 53.

Still further, in each of the embodiments described above, the connection portion 62 is more elastically deformable than the second mounting portion 53. However, the second mounting portion 53 may be more deformable than the connection portion 62. In this case, the deformation of the second mounting portion 53 may be any of elastic deformation and plastic deformation.

Further, in each of the embodiments described above, the connection portion 62 is more elastically deformable than the plate member 5 except for the second mounting portion 53, specifically, the plate main body portion 51 and the first mounting portions 52. However, the second mounting portion 53 may be more deformable than the plate member 5 except for the second mounting portion 53. Even in this manner, an excessive increase in pressure applied from the plate member 5 to the control unit main body 41 can be prevented through the deformation of the second mounting portion 53. Thus, the occurrence of breakage of the control unit 4 can be suppressed. In this case, the deformation of the second mounting portion 53 may be any of elastic deformation and plastic deformation. Thus, at least one of the connection portion 62 or the second mounting portion 53 is only required to be more deformable than the plate member 5 except for the second mounting portion 53.

Still further, in each of the embodiments described above, the second mounting portion 53 projects from the plate main body portion 51 toward the connection portion 62. However, as long as the connection portion 62 is mounted on the second mounting portion 53, the second mounting portion 53 is not required to project from the plate main body portion 51 toward the connection portion 62.

Still further, in each of the embodiments described above, the connection portion 62 projects from the electroconductive member main body portions 61 toward the second mounting portion 53. However, the connection portion 62 is only required to project from the cover 22. Thus, the connection portion 62 is not required to project from the electroconductive member main body portions 61 toward the second mounting portion 53.

Still further, in each of the embodiments described above, the number of second mounting portion 53 included in the plate member 5 is one. However, a plurality of second mounting portions 53 may be included in the plate member 5. In this case, positions of the plurality of second mounting portions 53 are set to be different from each other. Further, in this case, the electroconductive member 6 for plate connection, which includes a plurality of connection portions 62 to be individually mounted on the second mounting portions 53, respectively, is provided to the cover 22.

Still further, in each of the embodiments described above, the first end portion of the output shaft 31, which is located on the end wall portion 212 side of the case 21, serves as the output portion of the electric driving device 1. However, the second end portion of the output shaft 31, which is located on the control unit 4 side, may serve as the output portion of the electric driving device 1. In this case, the second end portion of the output shaft 31 passes through the control unit 4 and the cover 22 to project to the outside of the housing 2.

Still further, in each of the embodiments described above, the bearing 20 is fitted into the through hole formed in the frame 7. However, a housing cover different from the frame 7 may be fixed to an inner peripheral surface of the case 21 so that the bearing 20 is fitted into a through hole formed in the housing cover. In this case, the housing cover and the bearing 20 fitted into the through hole of the housing cover are arranged between the frame 7 and the connection ring 34. Further, in this case, the second end portion of the output shaft 31 is inserted into the through hole of the housing cover. As a result, in this case, the output shaft 31 is rotatably supported in the end wall portion 212 and the housing cover through the bearings 20 fitted into the through holes, respectively.

Still further, in each of the embodiments described above, the filter portion 42 includes the common-mode coil 421, the normal-mode coil 422, the X-capacitors 423 and 424, and the Y-capacitors 425 and 426. However, one of the common-mode coil 421 and the normal-mode coil 422 may be omitted depending on the noise generated from the control unit 4. Further, one or a plurality of ones of the X-capacitors 423 and 424 and the Y-capacitors 425 and 426 may be omitted.

Still further, in each of the embodiments described above, the electroconductive member 6 for plate connection, which has the connection portion 62, is different from the electroconductive member continuous with the power supply terminal 63 of the power supply connector 25 and the electroconductive member continuous with the ground terminal of the power supply connector 25. However, the electroconductive member continuous with the ground terminal of the power supply connector 25 may be used as the electroconductive member for plate connection, which has the connection portion 62. Specifically, the electroconductive member for plate connection may be electrically connected to the ground terminal of the power supply connector 25. As a result, a state of a harness ground, in which the electroconductive member for plate connection provided to the cover 22 is electrically connected to the ground line 132 through the ground terminal of the power supply connector 25, is achieved.

When the state of the harness ground is achieved as described above, the plate member 5 can be electrically connected to the vehicle body regardless of whether or not the plate member 5 is electrically connected to the case 21. As a result, the grounding of the control unit 4 can be more reliably achieved in a simple configuration. Further, selection of the structure to be employed from one of the structure in which the plate member 5 is electrically connected to the case 21 and the structure in which the outer peripheral portion of the plate member 5 is covered with a resin member having an insulating property to electrically insulate the plate member 5 from the case 21 can be flexibly made in terms of noise and heat radiation of the electric driving device 1.

Still further, when the normal-mode coil 422 of the filter portion 42 is not provided, the number of electroconductive members 6 can be reduced by the achievement of the state of the harness ground. When the normal-mode coil 422 is not provided, one of the terminals of each of the X-capacitors 423 and 424 is connected to the electroconductive member 6 for plate connection.

Still further, when the state of the harness ground is achieved, the case 21 can also be mounted to the vehicle body under a state in which an insulating object is provided between the case 21 and the vehicle body so as to interrupt electrical connection between the case 21 and the vehicle body. A state in which the case 21 is electrically connected to the vehicle body or a state in which the case 21 is electrically insulated from the vehicle body can be selected in accordance with, for example, sound, vibration, electromagnetic noise, and radio noise of the electric driving device 1.

### Reference Signs List

1 electric driving device, 2 housing, 3 motor, 4 control unit, 5 plate member, 6 electroconductive member, 7 frame, 15 protruding portion, 16 insertion hole, 21 case, 22 cover, 25 power supply connector, 41 control unit main body, 46 power supply relay (second heat generating component), 51 plate main body portion, 52 first mounting portion, 53 second mounting portion, 61 electroconductive member main body portion, 62 connection portion, 64 screw (coupling member), 441U U-phase power module (second heat generating component), 441V V-phase power module (second heat generating component), 441W W-phase power module (second heat generating component), 451 CPU (first heat generating component), 620 projecting portion

## Claims

1. An electric driving device, comprising:
a housing including:
a case having an opening portion; and
a cover configured to close the opening portion;
a motor housed in the case;
a control unit which includes a control unit main body configured to control the motor, and is arranged between the cover and the motor;
a plate member which is made of a material having electroconductivity, and is arranged between the cover and the control unit main body; and
an electroconductive member which is made of a material having electroconductivity, and is provided to the cover,
wherein the plate member includes:
a first mounting portion mounted to the control unit main body; and
a second mounting portion formed at a position different from a position of the first mounting portion,
wherein the electroconductive member has a connection portion which projects from the cover,
wherein the connection portion is mounted on the second mounting portion, and
wherein at least one of the second mounting portion or the connection portion is more deformable than the plate member except for the second mounting portion.

2. The electric driving device according to claim 1,
wherein the electroconductive member has an electroconductive member main body portion fixed to the cover, and
wherein the connection portion projects from the electroconductive member main body portion toward the second mounting portion.

3. The electric driving device according to claim 1 or 2,
wherein the plate member includes a plate main body portion having the first mounting portion and the second mounting portion, and
wherein the second mounting portion projects from the plate main body portion toward the connection portion.

4. The electric driving device according to any one of claims 1 to 3, wherein the connection portion is more deformable than the second mounting portion.

5. The electric driving device according to claim 4,
wherein the connection portion has a pair of projecting portions which are separate from each other, and
wherein the pair of projecting portions are mounted together on the second mounting portion.

6. The electric driving device according to any one of claims 1 to 4, wherein a protruding portion is formed on one of the second mounting portion and the connection portion, and an insertion hole into which the protruding portion is inserted is formed in the other one of the second mounting portion and the connection portion.

7. The electric driving device according to any one of claims 1 to 6,
wherein the case is made of a material having electroconductivity, and
wherein the plate member is electrically connected to the case.

8. The electric driving device according to any one of claims 1 to 7,
wherein each of the plate member and the case is made of a material having thermal conductivity,
wherein the control unit main body includes a first heat generating component, and
wherein the plate member is mounted to the first heat generating component and the case.

9. The electric driving device according to any one of claims 1 to 8,
wherein a power supply connector is provided to the cover,
wherein a ground terminal is exposed inside the power supply connector, and
wherein the electroconductive member is electrically connected to the ground terminal.

10. The electric driving device according to any one of claims 1 to 9, further comprising a frame which is arranged between the motor and the control unit, and is mounted to the case,
wherein each of the frame and the case is made of a material having thermal conductivity,
wherein the control unit main body includes a second heat generating component, and
wherein the second heat generating component is arranged on the frame through intermediation of bond or grease having an insulating property and thermal conductivity.
